# EUROPÄISCHE PATENTSCHRIFT

(11) **EP 0 839 346 B1**
(45) Veröffentlichungstag und Bekanntmachung des Hinweises auf die Patenterteilung: **27.01.1999**
(21) Anmeldenummer: 96923912.8
(22) Anmeldetag: 25.06.1996
(51) Int. Cl.: G06F 1/16

(54) **VORRICHTUNG ZUM ANBRINGEN EINES BEDIENFELDES AN DIE VORDERE UNTERKANTE EINES STEUERGERÄTES**
DEVICE FOR FITTING A CONTROL PANEL TO THE LOWER FRONT EDGE OF A CONTROL DEVICE
DISPOSITIF DE FIXATION D'UN TABLEAU DE COMMANDE SUR LE BORD INFERIEUR AVANT D'UN APPAREIL DE COMMANDE

(30) Priorität: 15.07.1995 DE 19525880
(43) Veröffentlichungstag der Anmeldung: 06.05.1998
(73) Patentinhaber: Rittal-Werk Rudolf Loh GmbH & Co. KG, 35745 Herborn (DE)
(72) Erfinder: NEUHOF, Markus, D-35630 Ehringshausen-Niederlemp (DE); REUTER, Wolfgang, D-57299 Burbach 5 (DE)
(74) Vertreter: Fleck, Hermann-Josef, Dr.-Ing.
(86) Internationale Anmeldenummer: EP9602757
(87) Internationale Veröffentlichungsnummer: WO9704379

(56) Entgegenhaltungen:
- EP-A- 0 360 384
- WO-A-95/05631
- GB-A- 2 212 879
- US-A- 4 669 053

## Beschreibung

Die Erfindung betrifft eine Vorrichtung zum Anbringen eines Bedienfeldes an die vordere Unterkante eines Steuergerätes.

Die Verwendung von Rahmen an der Vorderseite des Steuergerätes und an der Oberseite des Bedienfeldes bringt einen einfachen Aufbau dieser Geräte. Es besteht nun vielfach der Wunsch, ein Steuergerät und ein Bedienfeld dieser Art so miteinander zu verbinden, daß das Bedienfeld im Bereich der Unterkante des Steuergerätes abstehend angebracht werden muß.

Es sind Lösungen bekannt, bei denen das Steuergerät und das Bedienfeld eine Konstruktionseinheit darstellen und daher nur zusammen eingesetzt werden können.

Es ist Aufgabe der Erfindung, eine Vorrichtung der eingangs erwähnten Art zu schaffen, mit der getrennte Einheiten bildende Steuergeräte und Bedienfelder auf einfache Art miteinander verbunden werden können.

Diese Aufgabe wird nach der Erfindung dadurch gelöst, daß die Vorderseite des Steuergerätes und die Oberseite des Bedienfeldes mittels aus Rahmenschenkeln zusammengesetzten Rahmen umschlossen sind, daß der Rahmen des Steuergerätes und der Rahmen des Bedienfeldes über zwei Winkelstücke miteinander verbunden sind, deren Schenkel jeweils mit mindestens einer stirnseitig vorstehenden Schraubhülse versehen sind, und daß die Schraubhülsen in versenkte Schraubaufnahmen der Rahmen eingeführt und mittels Befestigungsschrauben mit diesen verschraubt sind, wobei die Stirnseiten der Schenkel der Winkelstücke an die anschließenden Außenkonturen der Rahmen bündig angepaßt sind oder daß die Vorderseite des Steuergerätes und die Oberseite des Bedienfeldes mittels aus Rahmenschenkeln zusammengesetzten Rahmen umschlossen sind, daß der Rahmen des Steuergerätes und der Rahmen des Bedienfeldes über ein einziges Winkelstück miteinander verbunden sind, dessen Schenkel jeweils mit mindestens zwei stirnseitig vorstehenden Schraubhülsen versehen sind, und daß die Schraubhülsen in versenkte Schraubaufnahmen der Rahmen eingeführt und mittels Befestigungsschrauben mit diesen verschraubt sind, wobei die Stirnseiten der Schenkel des Winkelstückes an die anschließenden Außenkonturen der Rahmen bündig angepaßt sind.

In beiden Fällen sind die einander zugekehrten Rahmen vom Steuergerät und Bedienfeld nur mit den Schraubaufnahmen zu versehen. Bei Bedarf kann mit zwei oder einem einzigen, entsprechend abgestimmten Winkelstück ein Steuergerät fest mit einem Bedienfeld verbunden werden, wobei die Winkelstücke oder das Winkelstück die Stellung des Bedienfeldes zum Steuergerät festlegen oder festlegt. Die Schraubaufnahmen in den Rahmen des Steuergerätes und des Bedienfeldes stören das Aussehen des Steuergerätes und des Bedienfeldes praktisch nicht. Die Winkelstücke bringen stets einen formschönen Übergang vom Steuergerät zum Bedienfeld praktisch nicht. Die Winkelstücke bringen stets einen formschönen Übergang vom Steuergerät zum Bedienfeld.

Nach einer Ausgestaltung kann vorgesehen sein, daß die Rahmenschenkel des Rahmens des Steuergerätes und die Rahmenschenkel des Rahmens des Bedienfeldes über Eckverbinder miteinander verbunden sind, daß sich die Schenkel der Winkelstücke über die zugekehrte Abmessung der Eckverbinder erstrecken und daß die Schraubaufnahmen für die Schraubhülsen der Winkelstücke in die Eckverbinder der Rahmen eingebracht sind oder daß die Rahmenschenkel des Rahmens des Steuergerätes und die Rahmenschenkel des Rahmens des Bedienfeldes über Eckverbinder miteinander verbunden sind, daß sich die Schenkel des einzigen Winkelstückes über die zugekehrte Abmessung des Rahmen erstrecken und daß die Schraubaufnahmen für die Schraubhülsen des Winkelstückes in den Eckverbindern der Rahmen eingebracht sind. Dann sind nur mit Schraubaufnahmen versehene Eckverbinder an den einander zugekehrten Rahmenseiten von Steuergerät und Bedienfeld erforderlich.

Ist vorgesehen, daß die Schenkel der Winkelstücke in einem Winkel größer 90° zueinander stehen, dann nimmt das Bedienfeld eine leicht geneigte Stellung ein, die die Bedienung vereinfacht und erleichtert.

Die Neigung des Bedienfeldes läßt sich einfach dadurch erreichen, daß die Schenkel der Winkelstücke über einen gekrümmten Übergangsabschnitt ineinander übergehen und daß die Schraubhülsen über erweiterte Kopfaufnahmen von diesem Übergangsabschnitt ausgehen.

Die Anpassung der Stirnseiten der Schenkel der Winkelstücke an die Außenl<ontur der Rahmen bzw. Eckverbinder wird dadurch einfach, daß die Schraubaufnahmen für die Schraubhülsen der Winkelstücke parallel zu den Ebenen der Rahmen in die Eckverbinder eingebracht sind.

Die Herstellung der Winkelstücke wird dadurch vereinfacht und verbilligt, daß die Schenkel der Winkelstücke bis auf die mit Kopfaufnahmen versehenen Schraubhülsen hohl ausgebildet sind.

Eine feste Verbindung wird dadurch sichergestellt, daß die Schraubaufnahmen in den Eckverbindern mit einem Aufnahmeabschnitt für die Schraubhülsen der Winkelstücke versehen sind, an den sich eine Gewindeaufnahme für die Befestigungsschraube anschließt. Die Befestigungsschrauben werden dabei mit ihren Schraubenköpfen von den erweiterten Kopfaufnahmen der Schraubhülsen aufgenommen und abgestützt, während sie mit ihrem Gewindeteil in die Gewindeaufnahmen der Schraubaufnahmen in den Rahmen bzw. Eckverbindern eingeschraubt werden.

Die Erfindung wird anhand eines in den Zeichnungen dargestellten Ausführungsbeispiels näher erläutert. Es zeigen
**Fig. 1** in perspektivischer Darstellung ein Steuergerät und ein Bedienfeld, die über zwei Winkelstücke miteinander verbunden werden,
**Fig. 2** in vergrößertem Maßstab ein Winkelstück mit einem gekrümmten Übergangsabschnitt zwischen seinen Schenkeln und
**Fig. 3** das Winkelstück nach Fig. 2 in anderer perspektivischer Ansicht.

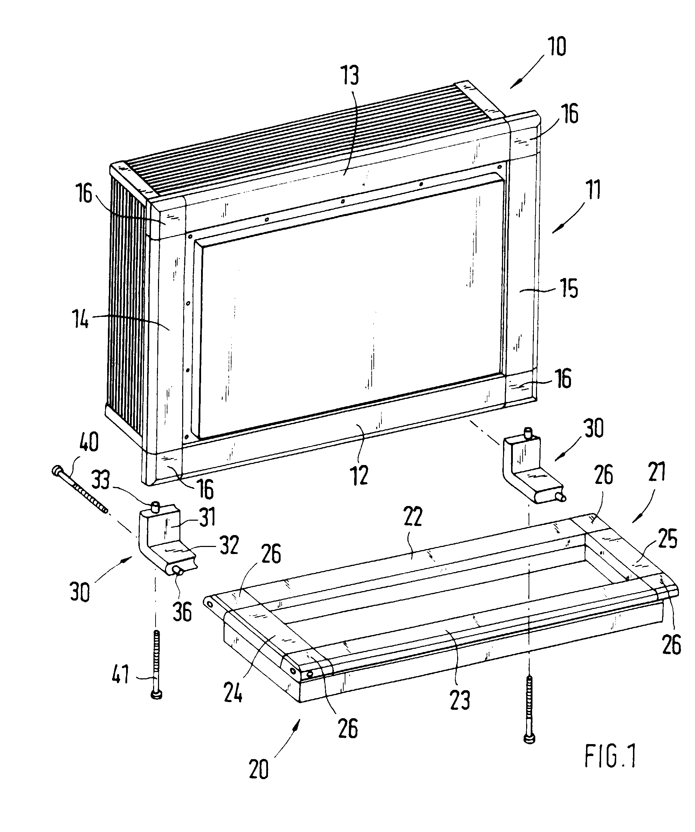

In Fig. 1 sind keine Einzelheiten des Steuergerätes 10 und des Bedienfeldes 20 gezeigt. Vielmehr sind nur die Teile bezeichnet, die für die erfindungsgemäße Vorrichtung erforderlich sind.

Die Vorderseite des Steuergerätes 10 ist von einem Rahmen 11 umschlossen, der aus den Rahmenschenkeln 12,13,14 und 15 sowie an allen Ecken mit Eckverbindern 16 zusammengesetzt ist. Der übrige Gehäuseaufbau und der Einbau von Teilen in die Frontseite ist hier nicht von Bedeutung. Ähnlich verhält es sich mit dem Bedienfeld 20, das an der Oberseite (Bedienseite) von einem Rahmen 21 aus Eckverbindern 26 und Rahmenschenkeln 22,23,24 und 25 umschlossen ist.

Im Ausführungsbeispiel sind für die Anbringung des Bedienfeldes 30 an dem Steuergerät 10 zwei Winkelstücke 30 vorgesehen, die die einander zugekehrten Rahmenschenkel 12 und 22 der Rahmen 11 und 12 im Bereich der Eckverbinder 16 und 26 miteinander verbinden. Die Winkelstücke 30 haben eine Breite, die der zugekehrten Abmessung der Eckverbinder 16 und 26 entspricht. An den freien Stirnseiten der Schenkel 31 und 32 der Winkelstücke 30 ragen Schraubhülsen 33 und 36 vor, die in entsprechende Schraubaufnahmen der Eckverbinder 6 und 26 eingeführt und mittels der Befestigungsschrauben 40 und 41 mit diesen verschraubt werden, um eine feste Verbindung zwischen dem Steuergerät 10 und dem Bedienfeld 20 zu erhalten. Stehen die Schenkel 31 und 32 der Winkelstücke 30 im rechten Winkel zueinander, dann steht das Bedienfeld 20 senkrecht zur Frontseite des Steuergerätes 10, wobei der Schenkel 31 den Abstand der Bedienseite des Bedienfeldes 20 von der Unterkante des Rahmens 11 festlegt.

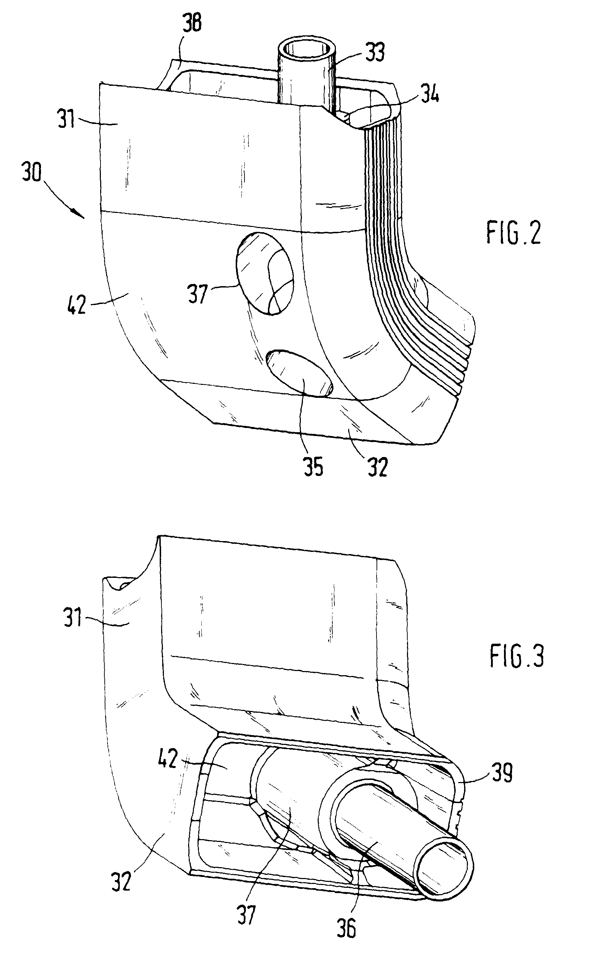

Die Fig. 2 und 3 zeigen in vergrößertem Maßstab ein Winkelstück 30, wie es bei der Anbringungsart nach Fig. 1 verwendet werden kann. Die Schenkel 31 und 32 sind im wesentlichen hohl ausgebildet und stehen über einen gekrümmten Übergangsabschnitt 42 in einem Winkel größer 90° zueinander, so daß damit eine geneigte Stellung des Bedienfeldes 20 erreicht werden kann.

Die Schraubhülse 33 geht im Schenkel 32 in eine erweiterte Kopfaufnahme 34 über, in der der Kopf der Befestigungsschraube 41 aufgenommen und abgestützt wird. Mit 35 ist im Übergangsabschnitt 42 der Zugang zur Kopfaufnahme 34 und Schraubhülse 33 gekennzeichnet. Mit 37 ist schließlich der Zugang für die Befestigungsschraube 40 zu der Kopfaufnahme 37 und zur Schraubhülse 36 gekennzeichnet. Die Stirnseiten 38 und 39 der Schenkel 31 und 32 sind an die Außenkontur der Eckverbinder 16 und 26 angepaßt, so daß stets ein bündiger Übergang erreicht wird.

Die Winkelstücke 30 können als Spritzgußteile aus Metall oder Kunststoff hergestellt werden.

Anstelle von zwei nur mit den Eckverbindern 16 und 26 verbundenen Winkelstücken 30 kann zum Anbringen des Bedienfeldes 20 an das Steuergerät 10 auch nur ein einziges, breites Winkelstück verwendet werden, das sich über die gesamte zugeordnete Rahmenabmessung erstreckt. Dieses breite Winkelstück trägt dann mindestens zwei Schraubhülsen 33 und 35, die die Verbindung zu beiden Eckverbindern 16 und 26 der Rahmenschenkel 12 und 22 der Rahmen 11 und 21 herstellen. Auf diese Weise kann ein vollkommen geschlossener Übergang zwischen Steuergerät 10 und Bedienfeld 20 erhalten werden.

Die Verbindungstellen können durchaus auch in den Bereich der Rahmenschenkel 12 und 22 gelegt werden. Der Verlagerung der Verbindungsstellen in den Bereich der Eckverbinder 16 und 26 ist jedoch der Vorzug zu geben, da die Rahmenschenkel 12 bis 15 und 22 bis 26 als einfache Profilabschnitte ausgebildet sein können. Dabei kann für die Rahmen 11 und 21 ein einheitliches Profil und für die Eckverbinder 16 und 26 eine einheitliche Ausgestaltung vorgesehen sein.

Die Verbindung zwischen dem Steuergerät 10 und dem Bedienfeld 20 kann auch so erfolgen, daß die Rahmenschenkel 12 bis 15 des Rahmens 11 des Steuergerätes 10 und die Rahmenschenkel 22 bis 25 des Rahmens 21 des Bedienfeldes 20 über Eckverbinder 16 bzw. 26 miteinander verbunden sind, daß die Schenkel 31,32 der Winkelstücke 30 durchgehende Schraubaufnahmen für die Befestigungsschrauben 40,41 aufweisen und daß die Befestigungsschrauben 40,41 in Schraubkanäle der Rahmenschenkel 14,15 bzw. 24,25 einschraubbar sind.

## Patentansprüche

1. Vorrichtung zum Anbringen eines Bedienfeldes an die vordere Unterkante eines Steuergerätes,
dadurch gekennzeichnet,
daß die Vorderseite des Steuergerätes (10) und die Oberseite des Bedienfeldes (20) mittels aus Rahmenschenkeln (12 bis 15, 22 bis 25) zusammengesetzten Rahmen (11,21) umschlossen sind,
daß der Rahmen (11) des Steuergerätes (10) und der Rahmen (21) des Bedienfeldes (20) über zwei Winkelstücke (30) miteinander verbunden sind, deren Schenkel (31,32) jeweils mit mindestens einer stirnseitig vorstehenden Schraubhülse (33,36) versehen sind, und
daß die Schraubhülsen (33,36) in versenkte Schraubaufnahmen der Rahmen (11,21) eingeführt und mittels Befestigungsschrauben (40,41) mit diesen verschraubt sind, wobei die Stirnseiten (38,39) der Schenkel (31,32) der Winkelstücke (30) an die anschließenden Außenkonturen der Rahmen (11,21) bündig angepaßt sind.

2. Vorrichtung zum Anbringen eines Bedienfeldes an die vordere Unterkante eines Steuergerätes,
dadurch gekennzeichnet,
daß die Vorderseite des Steuergerätes (10) und die Oberseite des Bedienfeldes (20) mittels aus Rahmenschenkeln (12 bis 15, 22 bis 25) zusammengesetzten Rahmen (11,21) umschlossen sind,
daß der Rahmen (11) des Steuergerätes (10) und der Rahmen (21) des Bedienfeldes (20) über ein einziges Winkelstück miteinander verbunden sind, dessen Schenkel jeweils mit mindestens zwei stirnseitig vorstehenden Schraubhülsen versehen sind, und
daß die Schraubhülsen in versenkte Schraubaufnahmen der Rahmen (11,21) eingeführt und mittels Befestigungsschrauben mit diesen verschraubt sind, wobei die Stirnseiten der Schenkel des Winkelstückes an die anschließenden Außenkonturen der Rahmen (11,21) bündig angepaßt sind.

3. Vorrichtung nach Anspruch 1,
dadurch gekennzeichnet,
daß die Rahmenschenkel (12 bis 15) des Rahmens (11) des Steuergerätes (10) und die Rahmenschenkel (22 bis 25) des Rahmens (21) des Bedienfeldes (20) über Eckverbinder (16 bzw. 26) miteinander verbunden sind,
daß sich die Schenkel (31,32) der Winkelstücke (30) über die zugekehrte Abmessung der Eckverbinder (16,26) erstrecken und
daß die Schraubaufnahmen für die Schraubhülsen (33,36) der Winkelstücke (30) in die Eckverbinder (16,26) der Rahmen (11,21) eingebracht sind.

4. Vorrichtung nach Anspruch 2,
dadurch gekennzeichnet,
daß die Rahmenschenkel (12 bis 15) des Rahmens (11) des Steuergerätes (10) und die Rahmenschenkel (22 bis 25) des Rahmens (21) des Bedienfeldes (20) über Eckverbinder (16 bzw. 26) miteinander verbunden sind,
daß sich die Schenkel des einzigen Winkelstückes über die zugekehrte Abmessung des Rahmen (11) erstrecken und
daß die Schraubaufnahmen für die Schraubhülsen des Winkelstückes in den Eckverbindern (16,26) der Rahmen (11,21) eingebracht sind.

5. Vorrichtung nach einem der Ansprüche 1 bis 4,
dadurch gekennzeichnet,
daß die Schenkel (31,32) der Winkelstücke (30) in einem Winkel größer 90° zueinander stehen.

6. Vorrichtung nach einem der Ansprüche 1 bis 5,
dadurch gekennzeichnet,
daß die Schenkel (31,32) der Winkelstücke (30) über einen gekrümmten Übergangsabschnitt (42) ineinander übergehen und
daß die Schraubhülsen (33,36) über erweiterte Kopfaufnahmen (34,37) von diesem Übergangsabschnitt ausgehen.

7. Vorrichtung nach einem der Ansprüche 1 bis 6,
dadurch gekennzeichnet,
daß die Schraubaufnahmen für die Schraubhülsen (33,36) der Winkelstücke (30) parallel zu den Ebenen der Rahmen (11,21) in die Eckverbinder (16,26) eingebracht sind.

8. Vorrichtung nach einem der Ansprüche 1 bis 7,
dadurch gekennzeichnet,
daß die Schenkel (31,32) der Winkelstücke (30) bis auf die mit Kopfaufnahmen (34,37) versehenen Schraubhülsen (33,36) hohl ausgebildet sind.

9. Vorrichtung nach einem der Ansprüche 1 bis 8,
dadurch gekennzeichnet,
daß die Schraubaufnahmen in den Eckverbindern (16,26) mit einem Aufnahmeabschnitt für die Schraubhülsen (33,36) der Winkelstücke (30) versehen sind, an den sich eine Gewindeaufnahme für die Befestigungsschraube (40 bzw. 41) anschließt.

10. Vorrichtung nach Anspruch 1,
dadurch gekennzeichnet,
daß die Rahmenschenkel (12 bis 15) des Rahmens (11) des Steuergerätes (10) und die Rahmenschenkel (22 bis 25) des Rahmens (21) des Bedienfeldes (20) über Eckverbinder (16 bzw. 26) miteinander verbunden sind,
daß die Schenkel (31,32) der Winkelstücke (30) durchgehende Schraubaufnahmen für die Befestigungsschrauben (40,41) aufweisen und daß die Befestigungsschrauben (40,41) in Schraubkanäle der Rahmenschenkel (14,15 bzw. 24,25) einschraubbar sind.

## Claims

1. Apparatus for fitting a control panel to the front lower edge of a control unit, characterised in that the front side of the control unit (10) and the upper side of the control panel (20) are surrounded by means of frames (11, 21) composed of frame portions (12 to 15, 22 to 25); in that the frame (11) of the control unit (10) and the frame (21) of the control panel (20) are interconnected via two angle pieces (30), the arms (31, 32) of which are each provided with at least one screw sleeve (33, 36) which protrudes at the end face; and in that the screw sleeves (33, 36) are inserted into the recessed screw receivers of the frames (11, 21) and are screw-connected thereto by means of securing screws (40, 41), the end faces (38, 39) of the arms (31, 32) of the angle pieces (30) being adapted to be flush with the adjacent external configurations of the frames (11, 21).

2. Apparatus for fitting a control panel to the front lower edge of a control unit, characterised in that the front side of the control unit (10) and the upper side of the control panel (20) are surrounded by means of frames (11, 21) composed of frame portions (12 to 15, 22 to 25); in that the frame (11) of the control unit (10) and the frame (21) of the control panel (20) are interconnected via a single angle piece, the arms of which are each provided with at least two screw sleeves which protrude at the end face; and in that the screw sleeves are inserted into the recessed screw receivers of the frames (11, 21) and are screw-connected thereto by means of securing screws, the end faces of the arms of the angle piece being adapted to be flush with the adjacent external configurations of the frames (11, 21).

3. Apparatus according to claim 1, characterised in that the frame portions (12 to 15) of the frame (11) of the control unit (10) and the frame portions (22 to 25) of the frame (21) of the control panel (20) are interconnected via corner connectors (16 or 26); in that the arms (31, 32) of the angle pieces (30) extend over the facing dimension of the corner connectors (16, 26); and in that the screw receivers for the screw sleeves (33, 36) of the angle pieces (30) are introduced into the corner connectors (16, 26) of the frames (11, 21).

4. Apparatus according to claim 2, characterised in that the frame portions (12 to 15) of the frame (11) of the control unit (10) and the frame portions (22 to 25) of the frame (21) of the control panel (20) are interconnected via corner connectors (16 and 26 respectively); in that the arms of the single angle piece extend over the facing dimension of the frame (11); and in that the screw receivers for the screw sleeves of the angle piece are introduced into the corner connectors (16, 26) of the frames (11, 21).

5. Apparatus according to one of claims 1 to 4, characterised in that the arms (31, 32) of the angle pieces (30) lie at an angle greater than 90° relative to each other.

6. Apparatus according to one of claims 1 to 5, characterised in that the arms (31, 32) of the angle pieces (30) pass into each other via a curved transitional portion (42); and in that the screw sleeves (33, 36) extend from this transitional portion via widened head receivers (34, 37).

7. Apparatus according to one of claims 1 to 6, characterised in that the screw receivers for the screw sleeves (33, 36) of the angle pieces (30) are introduced into the corner connectors (16, 26) parallel to the planes of the frames (11, 21).

8. Apparatus according to one of claims 1 to 7, characterised in that the arms (31, 32) of the angle pieces (30) have a hollow configuration apart from the screw sleeves (33, 36) which are provided with head receivers (34, 37).

9. Apparatus according to one of claims 1 to 8, characterised in that the screw receivers in the corner connectors (16, 26) are provided with a receiving portion for the screw sleeves (33, 36) of the angle pieces (30), with which screw receivers a threaded receiver for the securing screw (40 or 41) communicates.

10. Apparatus according to claim 1, characterised in that the frame portions (12 to 15) of the frame (11) of the control unit (10) and the frame portions (22 to 25) of the frame (21) of the control panel (20) are interconnected via corner connectors (16 and 26 respectively); in that the arms (31, 32) of the angle pieces (30) have continuous screw receivers for the securing screws (40, 41); and in that the securing screws (40, 41) can be screwed into screw channels of the frame portions (14, 15 and 24, 25 respectively).

## Revendications

1. Dispositif de fixation d'un tableau de commande sur le bord inférieur avant d'un appareil de commande,
caractérisé
en ce que la face avant de l'appareil de commande (10) et la face supérieure du tableau de commande (20) sont ceinturées par un cadre (11, 21) composé d'ailes d'encadrement (12 à 15, 22 à 25),
en ce que le cadre (11) de l'appareil de commande (10) et le cadre (21) du tableau de commande (20) sont reliés au moyen de deux cornières (30) dont les ailes (31, 32) présentent chacune au moins une douille filetée (33, 26) faisant protubérance frontalement, et
en ce que les douilles filetées (33, 36) sont introduites dans des logements filetés noyés des cadres (11, 21) et y sont fixées au moyen de vis de fixation (40, 41), les faces frontales (38, 39) des ailes (31, 32) des cornières (30) étant situées à fleur des contours extérieurs contigus des cadres (11, 21).

2. Dispositif de fixation d'un tableau de commande sur le bord inférieur avant d'un appareil de commande,
caractérisé
en ce que la face avant de l'appareil de commande (10) et la face supérieure du tableau de commande (20) sont ceinturées par un cadre (11, 21) composé d'ailes d'encadrement (12 à 15, 22 à 25),
en ce que le cadre (11) de l'appareil de commande (10) et le cadre (21) du tableau de commande (20) sont reliés au moyen d'une seule cornière dont les ailes présentent au moins deux douilles filetées faisant protubérance frontalement, et
en ce que en ce que les douilles filetées sont introduites dans des logements filetés noyés des cadres et y sont fixées au moyen de vis de fixation, les faces frontales des ailes des cornières étant situées à fleur des contours extérieurs contigus des cadres (11, 21).

3. Dispositif suivant la revendication 1,
caractérisé
en ce que les ailes d'encadrement (12 à 15) du cadre (11) de l'appareil de commande (10) et les ailes d'encadrement (22 à 25) du cadre (21) du tableau de commande (20) sont reliées au moyen de connecteurs d'angle (16 ou 26),
en ce que les ailes (31, 32) des cornières (30) s'étendent au-dessus de la portion des connecteurs d'angle 16, 26) qui leur fait face, et
en ce que les logements filetés pour les douilles filetées (33, 36) des cornières (30) sont pratiquées dans les connecteurs d'angle (16, 26) des cadres (11, 21).

4. Dispositif suivant la revendication 2,
caractérisé
en ce que en ce que les ailes d'encadrement (12 à 15) du cadre (11) de l'appareil de commande (10) et les ailes d'encadrement (22 à 25) du cadre (21) du tableau de commande (20) sont reliées au moyen de connecteurs d'angle (16 ou 26),
en ce que les ailes de la cornière unique s'étendent au-dessus de la portion qui leur fait du cadre (11), et
en ce que les logements filetés pour les douilles filetées de la cornière sont pratiquées dans les connecteurs d'angle (16, 26) des cadres (11, 21).

5. Dispositif suivant l'une quelconque des revendications de 1 à 4,
caractérisé
en ce que les ailes (31, 32) des cornières (30) forment un angle supérieur à 90°.

6. Dispositif suivant l'une quelconque des revendications de 1 à 5,
caractérisé
en ce que les ailes (31, 32) des cornières (30) se raccordent par l'intermédiaire d'un tronçon de transition incurvé (42), et
en ce que les douilles filetées (33, 36) sont par l'intermédiaire de logements de tête élargis (34, 37) issues de ce tronçon de transition.

7. Dispositif suivant l'une quelconque des revendications de 1 à 6,
caractérisé
en ce que les logements filetés pour les douilles filetées (33, 36) des cornières (30) sont pratiquées dans les connecteurs d'angle (16, 26) parallèlement aux plans des cadres (11, 21).

8. Dispositif suivant l'une quelconque des revendications de 1 à 7,
caractérisé
en ce que les ailes (31, 32) des cornières (30) sont creuses jusqu'aux douilles filetées (33, 36) présentant des logements de tête (34, 37).

9. Dispositif suivant l'une quelconque des revendications de 1 à 8,
caractérisé
en ce que les logements filetés dans les connecteurs d'angle (16, 26) sont dotés d'un tronçon de réception pour les douilles filetées (33, 36) des cornières (30) tronçon de réception auquel se raccorde un logement fileté pour la vis de fixation (40 ou 41).

10. Dispositif suivant la revendication 1,
caractérisé
en ce que les ailes d'encadrement (12 à 15) du cadre (11) de l'appareil de commande (10) et les ailes d'encadrement (22 à 25) du cadre (21) du tableau de commande (20) sont reliées au moyen de connecteurs d'angle (16 ou 26),
en ce que les ailes (31, 32) des cornières (30) présentent des logements filetés continus pour les vis de fixation (40, 41), et
en ce que les vis de fixation (40, 41) peuvent être vissées dans ces canaux filetés des ailes d'encadrement (14, 15 ou 24, 25).
